# EUROPÄISCHE PATENTSCHRIFT

(11) **EP 0 533 164 B1**
(45) Veröffentlichungstag und Bekanntmachung des Hinweises auf die Patenterteilung: **31.03.1999**
(21) Anmeldenummer: 92115937.2
(22) Anmeldetag: 09.12.1987
(51) Int. Cl.: H01L 21/00

(54) **Ball-Bondverfahren und Vorrichtung zur Durchführung desselben**
Ball bonding method and apparatus for using the same
Méthode de jonction par bille et dispositif associé

(30) Priorität: 06.02.1987 DE 3703694
(43) Veröffentlichungstag der Anmeldung: 24.03.1993
(62) Teilanmeldung aus: 87907960.6
(73) Patentinhaber: F & K Delvotec Bondtechnik GmbH, 85521 Ottobrunn (DE)
(72) Erfinder: Farassat, Farhad, W-8628 Taufkirchen (DE); Birgel, Walter, W-8016 Feldkirchen (DE)
(74) Vertreter: Popp, Eugen, Dr.

(56) Entgegenhaltungen:
- GB-A- 1 468 974
- US-A- 3 767 101
- US-A- 3 941 486
- US-A- 4 586 642

## Beschreibung

Die Erfindung betrifft ein Ball-Bondverfahren, wie ein Golddraht-Bondverfahren, nach dem Oberbegriff des Anspruches 1 und eine Vorrichtung zur Durchführung des Verfahrens nach dem Oberbegriff des Anspruches 3.

Ein solches Ball-Bondverfahren ist aus der US-A-4,586,642 bekannt. Bei diesem Verfahren wird zunächst der Bondkopf bzw. eine diesem zugeordnete Bond-Kapillare mit einer abgeflammten Bonddraht-Kugel (Ball) am unteren, freien Ende eines Bonddrahtes aus einer hochgefahrenen Ausgangsposition auf eine erste Bondstelle positioniert und abgesenkt. Sodann wird der Ball unter Wärmezugabe, definiertem Anpreßdruck und/oder Ultraschallunterstützung auf der ersten Bondstelle aufgeschweißt. Hiernach wird die Bondkapillare hochgefahren und eine Bonddraht-Schleife oder loop gebildet. Anschließend wird der Bonddraht wiederum unter Wärmezugabe, definiertem Anpreßdruck und/oder Ultraschallunterstützung an einer zweiten Bondstelle aufgeschweißt. Daraufhin wird der Bondkopf bzw. die Bond-Kapillare in eine vorgegebene tail-length-Position hochgefahren, der Bonddraht durch Ausübung eines Zuges auf diesen mittels einer am Bonddraht angreifenden Drahtklammer abgerissen und anschließend die Bond-Kapillare in die Ausgangsposition angehoben. Letztlich wird das freie Bonddrahtende unter Ausbildung eines neuen Balls abgeflammt, so daß dieses Ball-Bondverfahren erneut durchgeführt werden kann.

Ebenso ist in der US-A-4,586,642 eine Vorrichtung zur Durchführung dieses Ball-Bondverfahrens beschrieben. Diese Vorrichtung umfaßt eine Bond-Kapillare mit einem Bonddraht, die auf bzw. von Bondstellen zu- bzw. wegbewegbar, d. h. hier absenkbar bzw. hochfahrbar, ist. Des weiteren weist diese Vorrichtung eine am Bonddraht angreifende Drahtklammer auf, die ebenfalls auf bzw. von den Bondstellen zu- bzw. wegbewegbar und somit absenkbar bzw. hochfahrbar ist. Schließlich ist bei dieser Vorrichtung eine Einrichtung zum Anlegen einer elektrischen Spannung zwischen der Drahtklammer und der einen Bondstelle vorgesehen. Eine solche Einrichtung umfaßt einen ringförmigen, den Bonddraht umgebenden und zwischen der Bond-Kapillare einerseits und der Drahtklammer andererseits angeordneten Magnetkern sowie eine mit dem Magnetkern zusammenwirkende Spule, welche an einen Oszillator angeschlossen ist. Der Oszillator, der selbst in einem Computersystem integriert ist, erzeugt bestimmte Frequenzspannungen in vorgegebenen Zeitintervallen. Anhand einer Eichkurve, bei welcher die Frequenz über der Zeit aufgetragen ist, soll ein Vergleich mit der jeweiligen tatsächlichen Kurve des momentanen Bondvorganges, bei welcher ebenfalls die Frequenz über der Zeit aufgetragen ist, stattfinden können. Anhand eines solchen Vergleiches wiederum sollen bei einem bestimmten Bondvorgang auftretende Unregelmäßigkeiten durch Abweichungen in der Frequenz und/oder Zeit festgestellt und sodann für weitere nachfolgende Bondvorgänge durch entsprechende Korrektur behoben werden können.

Aus der US-A-3,941,486 ist eine Vorrichtung zur Durchführung des Ball-Bondverfahrens beschrieben. Für die Durchführung dieses bekannten Ball-Bondverfahrens wird eine Abflammlanze zum Abflammen des Drahtendes, das den Ball formt, in die Nähe des Drahtes gebracht. Ein wichtiger Faktor für die Steuerung der Ballgröße ist die Länge des Drahtes unterhalb der Bond-Kapillare und der Ort des Drahtendes relativ zu der Position der Abflammlanze.

Bei der zunehmend fortschreitenden Miniaturisierung der Bauelemente und damit der Bond- bzw. Kontaktstellen ist es erforderlich, die Ball-Größe entsprechend klein zu bemessen, um Kurzschlüsse zwischen benachbarten Bond- bzw. Kontaktstellen zu vermeiden. Darüberhinaus wird gefordert, die erwähnten "Mini-Balls" exakt zu dimensionieren. Diese beiden Voraussetzungen lassen sich jedoch mit dem herkömmlichen beschriebenen Ball-Bondverfahren nicht ohne weiteres erfüllen. Dies ist durch die Dehnung des meist sehr dünnen Golddrahtes bis zu 10 %, den Schlupf zwischen dem Bonddraht einerseits und der den Abriß desselben bewirkenden Drahtklammer andererseits sowie die durch innere Spannungen bedingte Verformung des Bonddrahtes, insbesondere seitliche Ausbiegung desselben, im unbelasteten Zustand nach der Aufschweißung an der zweiten Bondstelle bedingt. Eine Folge hiervon wiederum sind beim bisherigen Ball-Bondverfahren eine sehr undefinierte sog. "tail-length" und dementsprechend eine verhältnismäßig unbestimmte Ball-Größe.

Der vorliegenden Erfindung liegt die Aufgabe zugrunde, ein Ball-Bondverfahren der genannten Art sowie eine Vorrichtung zu dessen Durchführung zu schaffen, mit dem bzw. der sich die Ball-Größe exakt einstellen läßt, und zwar insbesondere auch bei Ausbildung von sog. "Mini-Balls".

Diese Aufgabe wird durch die kennzeichnenden Maßnahmen des Anspruches 1 in verfahrenstechnischer Hinsicht und durch die kennzeichnenden Merkmale des Anspruches 3 in vorrichtungstechnischer Hinsicht gelöst.

Das erfindungsgemäße Ball-Bondverfahren liefert neben der Lösung der gestellten Aufgabe zusätzlich weitere Informationen. Wenn bei dem Ball-Bondverfahren nach der Erfindung nach vorbestimmter Absenkung des Bondkopfes noch immer kein Kontakt zwischen dem freien Bonddrahtende und der in Abflammstellung gebrachten bzw. eingeschränkten Einrichtung zum Abflammen des Bonddrahtendes feststellbar ist, bedeutet dies, daß die "tail-length" so kurz sein muß, daß ein ausreichend groß bemessener Ball nicht mehr herstellbar ist. In diesem Fall wird der Bonder insgesamt vorzugsweise abgeschaltet und nach Untersuchung und Beseitigung des Fehlers dann wieder neu eingestellt. Das erfindungsgemäße Ball-Bondverfahren erlaubt also, zusätzliche Fehlersignale zu erkennen.

Weitere Details des erfindungsgemäßen Ball-Bondverfahrens sind in Anspruch 2 beschrieben.

Darüber hinaus ermöglicht die erfindungsgemäße Vorrichtung nach Anspruch 3 eine Durchführung des zuvor beschriebenen Ball-Bondverfahrens.

Vorteilhafte Merkmale der erfindungsgemäßen Vorrichtung sind in den Ansprüchen 4 und 5 beschrieben.

Nachstehend wird anhand einer Prinzip-Zeichnung das erfindungsgemäße Verfahren nochmals erläutert. Es zeigen:

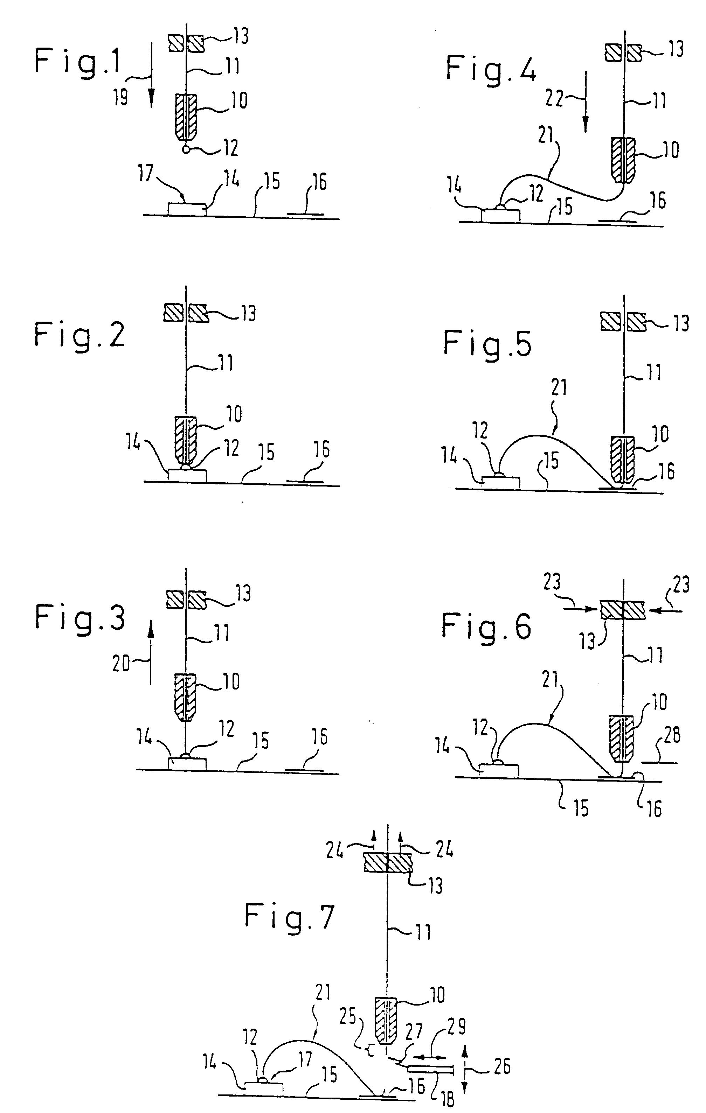

- Fig. 1 bis 7: den prinzipiellen Verfahrensablauf des erfindungsgemäßen Ball-Bondverfahrens.

In der anliegenden Zeichnung sind mit der Bezugsziffer 10 eine Bond-Kapillare, 11 ein Gold-Bonddraht mit einem Mini-Ball 12 am unteren freien Drahtende, 13 eine am Bonddraht 11 angreifende Drahtklammer, 14 ein Bauelement mit einer ersten Bondstelle 17, 15 ein lead-frame, 16 eine zweite Bondstelle auf dem Lead-frame bzw. Substrat, und 18 eine Abflammlanze gekennzeichnet.

Ausgehend von einer hochgefahrenen Ausgangsposition eines im einzelnen nicht näher dargestellten Bondkopfes wird der Bondkopf samt Bond-Kapillare 10 mit abgeflammter Bonddraht-Kugel bzw. Ball 12 auf eine erste Bondstelle 17 auf einem Bauelement 14 abgesenkt, entsprechend Pfeil 19 in Fig. 1. Die Absenkung der Bond-Kapillare 10 erfolgt unter Mitnahme des Balls 12 und damit entsprechender Mitnahme des Bonddrahtes 11. Anschließend erfolgt das Aufschweißen des Balls 12 an der ersten Bondstelle 17 auf dem Bauelement 14 unter Wärmezugabe definiertem Anpreßdruck und/oder Ultraschallunterstützung.

Dann wird der Bondkopf bzw. die Bond-Kapillare 10 wieder hochgefahren (siehe Pfeil 20 in Fig. 3) und in eine vorgegebene Loop-Position entsprechend Fig. 4 bewegt, unter Ausbildung einer sogenannten Bonddraht-Schleife 21. In der Loop-Position befindet sich die Bond-Kapillare oberhalb der zweiten Bondstelle 16. Die Bond-Kapillare wird dann unter entsprechender Mitnahme des Bonddrahtes 11 aus der Loop-Position erneut abgesenkt (siehe Pfeil 22 in Fig. 4). In abgesenkter Stellung entsprechend Fig. 5 erfolgt dann das Aufschweißen des Bonddrahtes 11 an der zweiten Bondstelle 16 ebenfalls unter Wärmezugabe, definiertem Anpreßdruck und/oder Ultraschallunterstützung.

Dann wird der Bondkopf bzw. die Bond-Kapillare 10 in tail-length-Position 28 gefahren entsprechend Fig. 6. Anschließend wird die Drahtklammer 13 aktiviert und entsprechend den Pfeilen 23 in Fig. 6 in Drahtklemmstellung gebracht. Dann wird zwischen der Drahtklammer und der zweiten Bondstelle 16 eine elektrische Spannung angelegt, gegebenenfalls über den lead-frame 15. Sobald diese Spannung anliegt wird die Drahtklammer 13 entsprechend den Pfeilen 24 in Fig.7 nach oben bewegt bzw. hochgefahren unter entsprechender Ausübung eines Zuges auf den Bonddraht 11, bis dieser abreißt. Mit dem Abriß des Bonddrahtes 11 wird die elektrische Verbindung zwischen Drahtklammer 13 und zweiter Bondstelle 16 unterbrochen. Die Zug- bzw. Abreißbewegung der Drahtklammer 13 wird gestoppt. Gleichzeitig wird die Wegstrecke festgehalten, die die Drahtklammer 13 in Richtung der Pfeile 24 bis zum Abriß des Bonddrahtes 11 zurückgelegt hat.

Nach dem Abriß des Bonddrahtes 11 wird die hochgefahrene Bond-Kapillare 10 wieder abgesenkt, bis die freie Drahtspitze die mittlerweile in Abflammstellung gebrachte bzw. eingeschwenkte Abflammlanze oder einen entsprechenden Anschlag kontaktiert. Dann braucht der Bondkopf nur noch so weit angehoben zu werden, bis ein vorbestimmter Abstand zwischen der freien Drahtspitze und der Abflammlanze 18 erreicht ist. Auf diese Weise läßt sich die Ball-Größe dauerhaft exakt bestimmen. Die Abflammlanze 18 führt bei dem Verfahren lediglich eine Bewegung in Richtung des Doppelpfeiles 29 in Fig. 7 aus.

Auf diese Weise ist die tatsächliche tail-length 25 (Fig. 7) bzw. die exakte Position des freien Bonddrahtendes oberhalb der zweiten Bondstelle 16 bestimmbar, so daß es möglich ist, die Einrichtung zum Abflammen des freien Bonddrahtendes unter Ausbildung eines neuen Balls 12, nämlich die Abflammlanze 18, gegenüber dem freien Bonddrahtende bzw. der Drahtspitze so zu positionieren (siehe Doppelpfeil 29 in Fig.7), daß die Abflammlanze 18 stets einen vorbestimmten Abstand zur Bonddrahtspitze aufweist. Dann wird die Abflammlanze 18 aktiviert (Abflammfunke 27), so daß sich der tail 25 zu einem neuen Ball 12 verformt.

Anschließend wird die Drahtklammer 13 wieder geöffnet und in die Ausgangsposition gemäß Fig. 1 abgesenkt. Ein neuer Bondvorgang der beschriebenen Art kann wieder beginnen.

Als Antrieb für die Drahtklammer 13 dient vorzugsweise ein Schrittmotor. Die von der Drahtklammer 13 zurückgelegte Wegstrecke bis zum Abriß des Bonddrahtes 11 wird dementsprechend in Schritten (clocks) festgehalten. Vorzugsweise erfolgt die Auf- und Abbewegung der Abflammlanze 18 in Richtung des Doppelpfeiles 26 ebenfalls mittels eines Schrittmotors, wobei die Zählwerke der beiden Schrittmotoren über eine Rechnereinheit miteinander gekoppelt sind, so daß die gewünschte Zuordnung der Abflammlanze 18 zur freien Drahtspitze selbsttätig bzw. vollautomatisch herstellbar ist.

Sobald sich die Drahtklammer 13 wieder in ihrer Startposition gemäß Fig. 1 befindet, wird das der Drahtklammer 13 zugeordnete Zählwerk wieder auf Null gestellt. Auch die Abflammlanze 18 wird nach dem Abflammen des tails 25 wieder in eine Nullposition gebracht. Sobald diese erreicht ist, wird das dem Antrieb der Abflammlanze 18 zugeordnete Zählwerk ebenfalls auf Null gestellt. Sowohl die Drahtklammer 13 als auch die Abflammlanze 18 befinden sich somit jeweils in Ausgangs- bzw. Startposition, von der aus die gegenseitige Positionierung von freier Drahtspitze und Abflammlanze 18 bestimmt und gesteuert wird.

Durch das beschriebene Verfahren ist es möglich, die eingangs genannten Erscheinungen bzw. Größen, wie Drahtdehnung und Drahtverformung (seitliche Ausbiegung im unbelasteten Zustand), als Fehlgrößen zur exakten Ball-Dimensionierung auszuschließen.

Als Kontaktsensor kann bei dem Verfahren ein herkömmlicher elektrischer (berührungsfreier), mechanischer oder Ultraschall-Sensor dienen.

Bei dem Verfahren läßt sich auch feststellen, ob überhaupt ein ausreichend langer tail 25 vorhanden ist. Sofern nämlich nach vorbestimmter Absenkung des Bondkopfes noch immer kein Kontakt zur Abflammlanze 18 hergestellt ist, bedeutet dies, daß die tail-length zu kurz ist, um einen ausreichend großen Ball 12 ausbilden zu können.

## Patentansprüche

1. Ball-Bondverfahren, wie ein Golddraht-Bondverfahren, welches folgende Arbeitsschritte umfaßt:
a) Positionieren und Absenken einer Bond-Kapillare (10) mit einer abgeflammten Bonddraht-Kugel (Ball 12) am unteren, freien Ende eines Bonddrahtes (11) aus einer hochgefahrenen Ausgangsposition auf eine erste Bondstelle (17);
b) Aufschweißen des Balls (12) unter Wärmezugabe, definiertem Anpreßdruck und/oder Ultraschallunterstützung;
c) Hochfahren der Bond-Kapillare (10);
d) Bildung einer Bonddraht-Schleife (21);
e) Aufschweißen des Bonddrahtes (11) an einer zweiten Bondstelle (16) unter Wärmezugabe, definiertem Anpreßdruck und/oder Ultraschallunterstützung;
f) Hochfahren der Bond-Kapillare (10) in eine vorgegebene tail-length-Position (28), Abreißen des Bonddrahtes (11) durch Ausübung eines Zuges auf diesen mittels einer am Bonddraht (11) angreifenden Drahtklammer (13) und anschließend Hochfahren der Bond-Kapillare (10) in die Ausgangsposition; sowie
g) Abflammen des freien Bonddrahtendes unter Ausbildung eines neuen Balls (12),
**dadurch gekennzeichnet,** daß
h) vor dem Abflammen des freien Bonddrahtendes eine als Einrichtung zum Abflammen des freien Bonddrahtendes vorgesehene Abflammlanze (18) in Abflammstellung gebracht bzw. eingeschwenkt wird;
i) anschließend die Bond-Kapillare (10) soweit abgesenkt wird, bis das freie Bonddrahtende bzw. die Drahtspitze die Abflammlanze (18) oder ein dieser zugeordnetes Wegbegrenzungs-Element kontaktiert; und
j) die Bond-Kapillare (10) so dann wieder um eine vorgegebene Wegstrecke soweit hochgefahren wird, bis das freie Bonddrahtende einen vorbestimmten Abstand von der Abflammlanze (18) aufweist.

2. Verfahren nach Anspruch 1,
dadurch gekennzeichnet, daß
die Kontaktierung des freien Bonddrahtendes mittels eines elektrischen, mechanischen und/oder Ultraschall-Sensors festgestellt wird.

3. Vorrichtung zur Durchführung des Verfahrens nach einem der Ansprüche 1 oder 2, umfassend eine Bond-Kapillare (10) mit einem Bonddraht (11), die auf bzw. von Bondstellen (16, 17) zu- bzw. wegbewegbar ist, einer am Bonddraht (11) angreifenden Drahtklammer (13), die auf bzw. von den Bondstellen (16, 17) zu- bzw. wegbewegbar ist, und einer Einrichtung zum Anlegen einer elektrischen Spannung zwischen der Drahtklammer (13) und der einen Bondstelle (16),
dadurch gekennzeichnet, daß
der den Abriß des Bonddrahtes (11) bewirkenden Drahtklammer (13) ein Schrittantrieb zugeordnet ist, der mit einem Zählwerk gekoppelt ist, welches die von der Drahtklammer (13) zurückgelegte Wegstrecke bestimmt und für die erneute Bestimmung einer weiteren Wegstrecke auf Null einstellbar ist und daß ein Kontaktsensor vorgesehen ist, zum Feststellen eines Kontaktes zwischen dem freien Bonddrahtende und der Abflammlanze (18) oder einem dieser angeordneten Wegbegrenzungs-Element.

4. Vorrichtung nach Anspruch 3,
dadurch gekennzeichnet, daß
eine als Einrichtung zum Abflammen des freien Bonddrahtendes vorgesehene Abflammlanze (18) auf bzw. von den Bondstellen (16, 17) zu bzw. wegbewegbar ist, wobei der Abflammlanze (18) ein Schrittantrieb zugeordnet ist, der mit einem Zählwerk gekoppelt ist, welches die von der Abflammlanze (18) zurückgelegte Wegstrecke bestimmt und für die erneute Bestimmung einer weiteren Wegstrecke auf Null einstellbar ist.

5. Vorrichtung nach Anspruch 3 oder 4,
dadurch gekennzeichnet, daß
der Kontaktsensor als elektrischer, mechanischer oder Ultraschall-Sensor ausgebildet ist.

## Claims

1. Ball bonding method, such as a gold-wire bonding method, which comprises the following process steps:
a) Positioning and lowering of a bonding capillary (10) having a singed bonding wire sphere (ball 12) on the lower, free end of a bonding wire (11) from a raised original position to a first bonding point (17);
b) Welding on the ball (12) while supplying heat, with a defined contact pressure and/or with ultrasound assistance;
c) Raising the bonding capillary (10);
d) Forming a bonding wire loop (21);
e) Welding the bonding wire (11) to a second bonding point (16) while supplying heat, with a defined contact pressure and/or with ultrasound assistance;
f) Raising the bonding capillary (10) to a predetermined tail-length position (28), tearing off the bonding wire (11) by exerting tension on it by means of a wire clip (13) which acts on the bonding wire (11), and subsequently raising the bonding capillary (10) to the original position; and
g) Singeing the free bonding-wire end to form a new ball (12),
characterized in that
h) Before singeing the free bonding-wire end, a singeing lance (18), which is provided as a device for singeing the free bonding-wire end, is moved or pivoted into the singeing position;
i) The bonding capillary (10) is then lowered until the free bonding-wire end or the wire tip makes contact with the singeing lance (18) or a movement-limiting element associated with it; and
j) The bonding capillary (10) is then raised again through a predetermined distance until the free bonding-wire end is at a predetermined distance from the singeing lance (18).

2. Method according to Claim 1,
characterized in that
the contact with the free bonding-wire end is confirmed by means of an electrical, mechanical and/or ultrasound sensor.

3. Apparatus for carrying out the method according to one of Claims 1 or 2, comprising a bonding capillary (10) having a bonding wire (11) which can be moved, respectively, towards and away from bonding points (16, 17), having a wire clip (13) which acts on the bonding wire (11) and, respectively, can be moved towards and away from the bonding points (16, 17), and having a device for applying an electrical voltage between the wire clip (13) and one bonding point (16),
characterized in that
the wire clip (13) which results in the bonding wire (11) being torn off is assigned a stepping drive which is coupled to a counting mechanism which determines the distance travelled by the wire clip (13) and can be set to zero in order once again to determine a further distance, and in that a contact sensor is provided in order to confirm a contact between the free bonding-wire end and the singeing lance (18) or a movement-limiting element associated with it.

4. Apparatus according to Claim 3,
characterized in that
a singeing lance (18) which is provided as a device for singeing the free bonding-wire end can be moved, respectively, towards and away from the bonding points (16, 17), the bonding lance (18) being assigned a stepping drive which is coupled to a counting mechanism which determines the distance travelled by the singeing lance (18) and can be set to zero in order once again to determine a further distance.

5. Apparatus according to Claim 3 or 4,
characterized in that
the contact sensor is designed as an electrical, mechanical or ultrasound sensor.

## Revendications

1. Procédé de liaison par bille, tel qu'un procédé de liaison par fil d'or, qui comprend les étapes suivantes :
a) positionnement et abaissement d'un capillaire de liaison (10) muni d'une boule de fil de liaison obtenue par flambage (bille 12) à l'extrémité libre inférieure d'un fil de liaison (11) d'une position de départ relevée à un premier point de liaison (17) ;
b) soudage de la bille (12) avec apport de chaleur, pression d'appui défini et/ou soutien par ultrasons ;
c) relevage du capillaire de liaison (10) ;
d) formation d'une boucle de fil de liaison (21) ;
e) soudage du fil de liaison (11) à un second point de liaison (16) avec apport de chaleur, pression d'appui définie et/ou soutien par ultrasons ;
f) relevage du capillaire de liaison (10) dans une position de longueur de traîne prédéfinie (28), rupture du fil de liaison (11) par application d'une traction sur celui-ci au moyen d'une pince à fil (13) en prise avec le fil de liaison (11) et ensuite relevage du capillaire de liaison (10) dans la position de départ ; ainsi que
g) flambage de l'extrémité libre du fil de liaison avec formation d'une nouvelle bille (12),
caractérisé en ce que
h) avant le flambage de l'extrémité libre du fil de liaison, une lance de flambage (18) prévue en tant qu'agencement pour le flambage de l'extrémité libre du fil de liaison est amenée ou basculée en position de flambage ;
i) après quoi le capillaire de liaison (10) est abaissé jusqu'à ce que l'extrémité du fil de liaison ou la pointe du fil vienne en contact avec la lance de flambage (18) ou un élément de limitation de course associé à celle-ci ; et
j) le capillaire de liaison (10) est ensuite relevé de nouveau d'une distance prédéfinie jusqu'à ce que l'extrémité libre du fil soit à une distance prédéterminée de la lance de flambage (18).

2. Procédé selon la revendication 1,
caractérisé en ce que
la mise en contact de l'extrémité libre du fil de liaison est déterminée au moyen d'un détecteur électrique, mécanique et/ou à ultrasons.

3. Dispositif pour la mise en oeuvre du procédé selon l'une des revendications 1 ou 2, comprenant un capillaire de liaison (10) muni d'un fil de liaison (11), qui peut être déplacé vers et depuis des points de liaison (16, 17), une pince à fil (13) en prise avec le fil de liaison (11), qui peut être déplacée vers et depuis les points de liaison (16, 17), et un agencement pour appliquer une tension électrique entre la pince à fil (13) et l'un des points de liaison (16),
caractérisé en ce que
la pince à fil (13) effectuant la rupture du fil de liaison (11) est associée à un moteur pas à pas couplé à un compteur qui détermine la distance parcourue par la pince à fil (13) et peut être remis à zéro pour la détermination renouvelée d'une distance suivante, et qu'un détecteur de contact est prévu pour établir un contact entre l'extrémité libre du fil et la lance de flambage (18) ou un élément de limitation de course associé à celle-ci.

4. Dispositif selon la revendication 3,
caractérisé en ce
qu'une lance de flambage (18) prévue en tant qu'agencement pour le flambage de l'extrémité libre du fil peut être déplacée vers et depuis les points de liaison (16, 17), à la lance de flambage (18) étant associé un moteur pas à pas couplé à un compteur qui détermine la distance parcourue par la lance de flambage (18) et peut être remis à zéro pour la détermination renouvelée d'une distance suivante.

5. Dispositif selon l'une des revendications 3 et 4,
caractérisé en ce que
le détecteur de contact est réalisé en tant que détecteur électrique, mécanique ou à ultrasons.
